# EUROPÄISCHE PATENTANMELDUNG

(11) **EP 0 982 111 A2**
(43) Veröffentlichungstag der Anmeldung: **01.03.2000**
(21) Anmeldenummer: 99114571.5
(22) Anmeldetag: 24.07.1999
(51) Int. Cl.: B29C 45/14, H05K 13/00

(54) **Einrichtung und Verfahren zum Vergiessen elektrischer Schaltungen mittels Spritzguss**

(30) Priorität: 22.08.1998 DE 19838266
(71) Anmelder: Mannesmann VDO Aktiengesellschaft, 60388 Frankfurt am Main (DE)
(72) Erfinder: Stotz, Oliver, 35789 Weilmünster (DE)
(74) Vertreter: Rassler, Andrea, Dipl.-Phys.

(57) **Zusammenfassung**

Bei einer Einrichtung und einem Verfahren zum Schutz einer elektrischen Schaltung vor Umgebungseinflüssen, wobei die Schaltung mit einem thermoplastischen Kunststoff umgeben ist, welcher durch Spritzguß aufgebracht ist, besteht der thermoplastische Kunststoff aus orientierten Makromolekülen. Die Bauteile der Schaltung sind mit ihrer gegen wechselnde Zugbelastung empfindlichsten Achse zum Ausgleich von Wärmespannungen im Mittel parallel zur jeweiligen in der Umgebung der Bauteile vorhandenen Fließrichtung des gespritzten Kunststoffes ausgerichtet.

## Beschreibung

Die Erfindung betrifft eine Einrichtung und ein Verfahren zum Schutz einer elektrischen Schaltung vor Umgebungseinflüssen, wobei die Schaltung mit einem thermoplastischen Kunststoff umgeben ist, welcher durch Spritzguß aufgebracht ist.

Derartige Kunststoffe finden ihre Anwendung häufig in der Automobilindustrie, wo elektrische Schaltungen in starkem Maße Schmutz und Feuchtigkeit ausgesetzt sind. Man umgibt die Schaltungen mit dem Kunststoff, der sie dicht versiegelt und damit unempfindlich macht gegen Feuchtigkeit und Schmutz. In DE 44 36 523 A1 wird eine Schaltung mit einem Kunststoff in Spritzgußtechnik umgeben. Dabei ergibt sich aber das Problem, daß die thermischen Spannungen, die bei Erwärmung der Schaltung auf die Bauteile wirken, aufgrund der hohen Wärmeausdehnung des Kunststoffes unzulässig hoch werden können und die Bauteile der Schaltung beschädigen.

Insbesondere können die Anschlußkontakte der Bauteile abreißen, da deren Anschlußstellen an den Bauteilen gegen wechselnde Zugbelastung empfindlich sind.

Aufgabe der vorliegenden Erfindung ist es, eine Einrichtung und ein Verfahren anzugeben, mit denen sich elektrische Schaltungen gegen Schmutz und Feuchtigkeit dauerhaft schützen lassen, ohne daß die Bauteile durch Wärmeausdehnung zu stark belastet werden.

Diese Aufgabe wird erfindungsgemäß dadurch gelöst, daß der thermoplastische Kunststoff gerichtet angeordnete Makromoleküle enthält und daß die Bauteile der Schaltung mit ihrer gegen wechselnde Zugbelastung empfindlichsten Achse im Mittel parallel zur jeweiligen in der Umgebung der Bauteile vorhandenen Richtung der Makromoleküle ausgerichtet sind. Besonders gut eignet sich hierzu ein thermotroper, flüssigkristalliner Thermoplast, wie er beispielsweise bei der Firma Hoechst unter dem Handelsnamen Vectra erhältlich ist.

Die Makromoleküle eines derartigen Polymers bilden im schmelzflüssigen Zustand flüssigkristalline Strukturen aus, so daß sie sich parallel zueinander ausrichten. Zudem richten sich die Makromoleküle während des Spritzens parallel zu den Hauptscherebenen des Kunststoffstromes aus, so daß sie also bei laminarer Strömung parallel zu den Wänden des Strömungskanales liegen. Der Wärmeausdehnungskoeffizient eines derart vergossenen Polymerkörpers ist senkrecht zu der mittleren Orientierungsrichtung der Makromoleküle höher als parallel dazu. Die stabförmigen Makromoleküle behindern das sie umgebende Material an der Ausdehnung und beeinflussen somit wirkungsvoll die spezifische Wärmeausdehnung des Gesamtmaterials. Aufgrund ihrer Lage längs der empfindlichen Achse der Bauteile ergibt sich daraus, daß die Wärmespannungen des Materials in axialer Richtung nicht auf die vergossenen Bauteile übertragen werden und diese vor Dauerlastbrüchen geschützt sind.

Der Wärmeausdehnungskoeffizient des Gesamtmaterials ist durch die Strömungsparameter während des Vergießens des flüssigen Kunststoffes in einem großen Bereich einstellbar. Beim Vergießen ist darauf zu achten, daß keine Fließnähte entstehen, daß die Strömung überwiegend laminar bleibt und daß der Kunststoffstrom in Richtung der Längsachsen der zu vergießenden Bauteile fließt. Der Kunststoff kann ferner, wie es schon häufig praktiziert wird, aus Festigkeitsgründen auch mit faserigen Substanzen, wie Glasfasern, versetzt sein.

Eine erste Ausgestaltung der Erfindung sieht vor, daß die Schaltung in einem festen Trägergehäuse gehalten ist, welches zumindest einen Teil der Spritzform für den thermoplastischen Kunststoff bildet. Das Trägergehäuse kann nach dem Vergießen an der Schaltung verbleiben und wirkt als stabilisierende Hülle. Während des Vergießens wird eine geeignete zweite Halbform gegen die offene Seite des Trägergehäuses gedrückt und nach dem Erkalten entfernt.

Bei einer nächsten Ausgestaltung der Erfindung ist vorgesehen, daß ein Gebilde aus eigenstabilen Leiterbahnen (Leadframe) teilweise in eine erste Schicht des Kunststoffes eingebettet ist, daß die Bauteile der Schaltung mit von der ersten Kunststoffschicht unbedeckten Stellen der Leiterbahnen verbunden sind und daß die Schaltung von einer zweiten Schicht des Kunststoffes umgeben ist. Dabei ist in vorteilhafter Weise vorgesehen, daß die erste Kunststoffschicht Formteile aufweist, mit welchen die Bauteile der Schaltung befestigt sind. Nach dem Ummanteln des Leadframes, was in Spritzgußtechnik geschieht, werden die Bauteile der Schaltung in oder auf die dafür vorgesehenen Formteile gesteckt und die Kontaktstifte mit den freigebliebenen Teilen der Leiterbahnen verlötet oder verschweißt. Anschließend wird die gesamte Anordnung mit dem Kunststoff umspritzt und somit versiegelt. Mit dieser Vorgehensweise lassen sich auch viele kleine Schaltungen auf einmal fertigen, indem man den Leadframe entsprechend aufteilt und nach dem Ummanteln an Verbindungsstegen auseinandertrennt.

Bei einer anderen Ausgestaltung der Erfindung ist vorgesehen, daß die Schaltung auf einen festen durch Spritzguß hergestellten Träger aufgebracht ist, der ebenfalls aus dem Kunststoff besteht, und daß die Schaltung mitsamt dem Träger von dem Kunststoff umgeben ist. Dabei ist es vorteilhaft, wenn die Leiterbahnen der Schaltung durch Heißprägen auf den Träger aufgebracht oder wenn sie auf den Träger aufgalvanisiert sind. Auf diese Weise kann die Schaltung auf dem stabilen Träger, wie auf einer herkömmlichen Leiterplatte, aufgebaut und anschließend mit dem Kunststoff ummantelt werden.

Schon bei der Herstellung des Trägers ist darauf zu achten, daß die gerichtete spezifische Wärmeausdehnung in Richtung der aufzubringenden Bauteile am kleinsten ist und daß die Bauteile der Schaltung vor dem Vergießen entlang der Fließrichtung und damit Hauptorientierungsrichtung der Makromoleküle des Kunststoffes ausgerichtet werden. Die Fließrichtung des Kunststoffes kann durch entsprechend verteilte Anspritzöffnungen in die gewünschte Richtung gesteuert werden. Vorteilhafterweise wird aus Fertigungsgründen eine längliche Trägerform gewählt, weil dann nur wenige Anspritzstellen benötigt werden - gegebenenfalls nur eine einzige.

Bei einer ersten Ausgestaltung des erfindungsgemäßen Verfahrens ist vorgesehen, daß die Schaltung in ein festes Gehäuse eingebracht und darin befestigt wird und daß das Gehäuse mit einem geeigneten Deckel verschlossen und anschließend mit dem Kunststoff ausgespritzt wird. Auf diese Weise lassen sich auch derartige Kunststoffe verwenden, deren mechanische Festigkeit zu gering ist, um eine haltbare Verkapselung der Schaltung zu gewährleisten. Bildet der Kunststoff eine chemisch haltbare Oberfläche aus, so kann vorgesehen sein, daß der Deckel nach dem Verspritzen wieder entfernt wird.

Zur Herstellung der Ausgestaltung mit Träger ist vorgesehen, daß die Leiterbahnen der Schaltung auf einen festen Träger aufgebracht werden, daß die Bauteile der Schaltung auf den Leiterbahnen befestigt werden und daß die Anordnung anschließend mit dem Kunststoff umgeben wird.

Zur Herstellung der Ausgestaltung mit eigenstabilen Leiterbahnen ist vorgesehen, daß ein Gebilde aus eigenstabilen Leiterbahnen (Leadframe) teilweise mit dem Kunststoff umgeben wird, wobei die Anschlußkontakte für die Bauteile der Schaltung freigelassen werden, daß die Bauteile auf den derart mit dem Kunststoff verstärkten Leadframe aufgebracht werden und daß die Anordnung anschließend mit dem Kunststoff umgeben wird.

Die Erfindung läßt zahlreiche Ausführungsformen zu. Eine davon ist schematisch in der Zeichnung anhand mehrerer Figuren dargestellt und nachfolgend beschrieben. Es zeigt:
- Fig. 1: eine erfindungsgemäß vergossene elektrische Schaltung in Schnittdarstellung,
- Fig. 2: dieselbe Schaltung in Draufsicht,
- Fig. 3: einen vergrößerten Ausschnitt der vergossenen Schaltung,
- Fig. 4: eine beschädigte Lötverbindung bei einem Schaltungsbauteil an einer nach einer herkömmlichen Methode vergossenen elektrischen Schaltung,
- Fig. 5: eine auf einem Träger montierte Schaltung in perspektivischer Ansicht, wobei die äußere Kunststoffhülle teilweise entfernt ist,
- Fig. 6: eine auf einem Leadframe montierte Schaltung in perspektivischer Ansicht, wobei die äußere Kunststoffhülle teilweise entfernt ist,
- Fig. 7: eine auf einem ummantelten Leadframe montierte Schaltung in perspektivischer Ansicht, wobei die Ummantelung und die äußere Kunststoffhülle teilweise entfernt sind und
- Fig. 8: eine auf einem ummantelten Leadframe montierte Schaltung in Draufsicht, wobei die Ummantelung und die äußere Kunststoffhülle teilweise entfernt sind.

Gleiche Teile sind in den Figuren mit gleichen Bezugszeichen versehen.

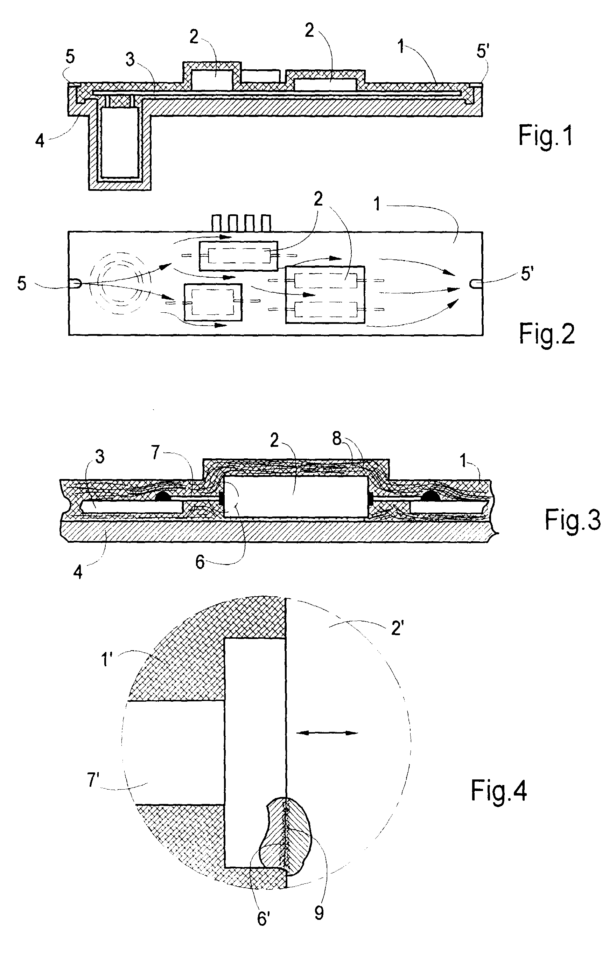

Fig. 1 zeigt eine elektrische Schaltung, die erfindungsgemäß mit einem Material 1 vergossen ist, in einer Schnittdarstellung. Die Schaltungsbauteile 2 sind an einem Leiterblech (Leadframe) 3 festgeschweißt. Die elektrische Schaltung wird während des Vergießens in einem starren Gehäuse 4 gehalten, das gleichzeitig als untere Gußformhälfte dient. Das Gehäuse 4 verbleibt nach dem Gußvorgang an der vergossenen Schaltung. Der Anspritzpunkt 5, an dem beim Vergießen der Kunststoff 1 eingespritzt wird, ist an der vergossenen Schaltung sichtbar. Gegenüber dem Anspritzpunkt 5 befindet sich eine Entlüftungsöffnung 5'.

In der Draufsicht der vergossenen Schaltung (Fig. 2) sind die Fließrichtungen des Kunststoffes 1 markiert, die er während des Vergießens einschlägt. Die Bauteile 2 der Schaltung sind mit ihren Achsen parallel zu der Fließrichtung angeordnet. Die Makromoleküle ordnen sich während des Vergießens entlang der Hauptscherebenen in dem flüssigen Kunststoff 1. Das heißt, daß die Moleküle sich bei laminarer Strömung parallel zu der Strömungsrichtung ausrichten und in dieser Ausrichtung im erstarrten Kunststoff 1 verbleiben. Dadurch ergibt sich eine faserige Struktur im Kunststoff 1, deren Strukturelemente allerdings molekulare Dimensionen haben. Im Gegensatz zu faserverstärkten Kunststoffen läßt sich damit nicht nur die Festigkeit des Materials positiv beeinflussen, sondern auch die spezifische Wärmeausdehnung in Längsrichtung nahezu beliebig verkleinern. Zusätzlich können auch Faserstoffe in den Kunststoff eingebracht werden, um die mechanische Festigkeit des Materials zu erhöhen.

Fig. 3 zeigt ein einzelnes Bauteil 2 in vergrößerter Darstellung. Die Lötstellen 6, mit denen die Kontaktierstifte 7 des Bauteils 2 an dem Bauteil 2 selbst befestigt sind, verkraften keine hohen Zugbelastungen. Auch sind sie empfindlich gegen wechselnde Zugbelastungen, wie sie durch thermische Spannungen erzeugt werden. An diesen Lötstellen 6 brechen die Kontaktierstifte 7 bei herkömmlich vergossenen Bauteilen häufig ab und die Schaltung wird unbrauchbar. Wird das Bauteil 2, wie dargestellt, vor dem Vergießen längs der Fließrichtung des Kunststoffes 1 ausgerichtet, so ordnen sich die Makromoleküle 8 parallel zu der Achse des Bauteils 2 an. Sie entlasten in dieser Position die empfindlichen Lötstellen 6 des Bauteils 2 beim Auftreten von thermischen Spannungen. Die spezifische Wärmeausdehnung der Vergußmasse 1 entspricht in Längsrichtung derjenigen der Schaltungsbauteile 2.

In Fig. 4 ist eine beschädigte Lötstelle 6' an einem mit herkömmlicher Vergußmasse 1' vergossenen Bauteil 2' vergrößert dargestellt. Durch die wechselnde Zugbelastung aufgrund von thermischen Spannungen ist ein Riß 9 entstanden, der nach einiger Zeit zum Ausfall des Bauteils 2' führen kann.

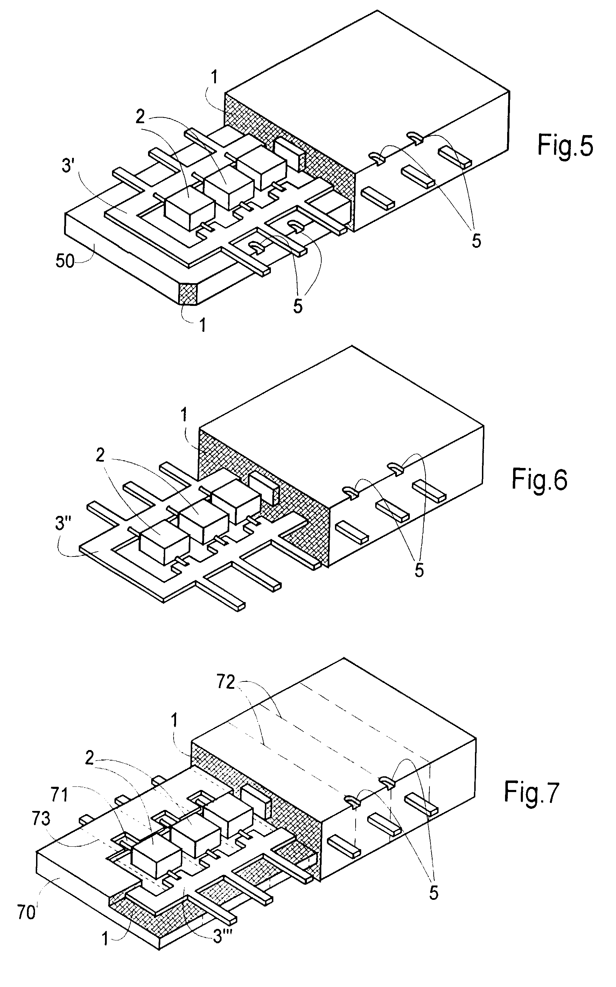

Eine auf einem Träger 50 aufgebaute Schaltung ist in Fig. 5 dargestellt. Die Leiterbahnen 3' können durch Heißprägung oder durch Galvanisieren aufgebracht sein. Bei der Verwendung von eigenstabilen Leiterblechen 3'', sogenannten Leadframes, kann, wie in Fig. 6 dargestellt, ein Träger ganz entfallen. Die Schaltung wird dabei an dem Leiterblech 3'' aufgebaut und dann vergossen.

Soll ein sehr dünner Leadframe 3''' verwendet werden oder sollen mehrere kleine Schaltungen auf einmal hergestellt werden, so muß das Leadframe erst mit einem stabilisierenden Mantel 70, wie Fig. 7 zeigt, aus dem Kunststoff umgeben werden. Dabei bleiben die Anschlußstellen 71 für die Bauteile 2 der Schaltung zunächst frei. Entlang der gestrichelten Linien 72 kann die fertige Schaltung ggf. zerteilt werden, um die einzelnen Schaltungen zu erhalten. Bei einer anderen Vorgehensweise wird der ummantelte Leadframe vor dem endgültigen Vergießen an den gestrichelten Linien 73 zerteilt. Die damit entstehenden Einzelteile werden anschließend einzeln vergossen.

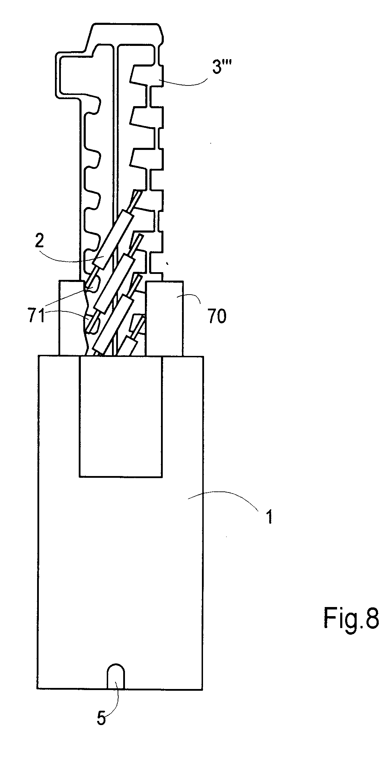

Fig. 8 zeigt ein weiteres Beispiel für die Verwendung eines ummantelten Leadframes, wobei aus Fertigungsgründen eine längliche Form der Schaltung gewählt wurde. Die Bauteile der Schaltung liegen in diesem Fall schräg, so daß sich eine Platzersparnis ergibt. Das Leadframe 3''' wird mit einem Mantel 70 umgeben. Anschließend werden die Bauteile 2 an den dafür vorgesehenen Kontaktblechen 71 befestigt und die gesamte Anordnung wird vergossen.

## Patentansprüche

1. Einrichtung zum Schutz einer elektrischen Schaltung vor Umgebungseinflüssen, wobei die Schaltung mit einem thermoplastischen Kunststoff umgeben ist, welcher durch Spritzguß aufgebracht ist, dadurch gekennzeichnet, daß der thermoplastische Kunststoff (1) gerichtet angeordnete Makromoleküle (8) enthält und daß die Bauteile (2) der Schaltung mit ihrer gegen wechselnde Zugbelastung empfindlichsten Achse im Mittel parallel zur jeweiligen in der Umgebung der Bauteile vorhandenen Richtung der Makromoleküle (8) ausgerichtet sind.

2. Einrichtung nach Anspruch 1, dadurch gekennzeichnet, daß der Kunststoff ein thermotropes flüssigkristallines Polymer ist.

3. Einrichtung nach Anspruch 1, dadurch gekennzeichnet, daß die Schaltung in einem festen Trägergehäuse (4) gehalten ist, welches zumindest einen Teil der Spritzform für den thermoplastischen Kunststoff (1) bildet.

4. Einrichtung nach Anspruch 1, dadurch gekennzeichnet, daß ein Gebilde aus eigenstabilen Leiterbahnen (Leadframe) (3''') teilweise in eine erste Schicht (70) des Kunststoffes eingebettet ist, daß die Bauteile (2) der Schaltung mit von der ersten Kunststoffschicht (70) unbedeckten Stellen (71) der Leiterbahnen (3''') verbunden sind und daß die Schaltung von einer zweiten Schicht des Kunststoffes (1) umgeben ist.

5. Einrichtung nach Anspruch 4, dadurch gekennzeichnet, daß die erste Kunststoffschicht Formteile aufweist, mit welchen die Bauteile der Schaltung befestigt sind.

6. Einrichtung nach Anspruch 1, dadurch gekennzeichnet, daß die Schaltung auf einen festen durch Spritzguß hergestellten Träger (50) aufgebracht ist, der ebenfalls aus dem Kunststoff besteht, und daß die Schaltung mitsamt dem Träger (50) von dem Kunststoff (1) umgeben ist.

7. Einrichtung nach Anspruch 6, dadurch gekennzeichnet, daß die Leiterbahnen (3') der Schaltung durch Heißprägen auf den Träger (50) aufgebracht sind.

8. Einrichtung nach Anspruch 6, dadurch gekennzeichnet, daß die Leiterbahnen (3') der Schaltung auf den Träger (50) aufgalvanisiert sind.

9. Verfahren zum Schutz einer elektrischen Schaltung nach einem der vorhergehenden Ansprüche, wobei die Schaltung mit einem thermoplastischen Kunststoff umgeben ist, welcher durch Spritzguß aufgebracht ist, dadurch gekennzeichnet, daß die Bauteile (2) der Schaltung vor dem Vergießen entlang der Fließrichtung und damit Hauptorientierungsrichtung der Makromoleküle (8) des Kunststoffes (1) ausgerichtet werden.

10. Verfahren nach Anspruch 9, dadurch gekennzeichnet, daß die Schaltung in ein festes Gehäuse (4) eingebracht und darin befestigt wird und daß das Gehäuse (4) mit einem geeigneten Deckel verschlossen und anschließend mit dem Kunststoff (1) ausgespritzt wird.

11. Verfahren nach Anspruch 9, dadurch gekennzeichnet, daß der Deckel nach dem Verspritzen wieder entfernt wird.

12. Verfahren nach Anspruch 9, dadurch gekennzeichnet, daß die Leiterbahnen (3') der Schaltung auf einen festen Träger (50) aufgebracht werden, daß die Bauteile (2) der Schaltung auf den Leiterbahnen (3') befestigt werden und daß die Anordnung anschließend mit dem Kunststoff (1) umgeben wird.

13. Verfahren nach Anspruch 9, dadurch gekennzeichnet, daß ein Gebilde aus eigenstabilen Leiterbahnen (Leadframe) (3''') teilweise mit dem Kunststoff (70) umgeben wird, wobei die Anschlußkontakte (71) für die Bauteile der Schaltung freigelassen werden, daß die Bauteile (2) auf den derart mit dem Kunststoff (70) verstärkten Leadframe (3''') aufgebracht werden und daß die Anordnung anschließend mit dem Kunststoff (1) umgeben wird.
